(19) Europäisches Patentamt / European Patent Office / Office européen des brevets

(11) **EP 4 004 493 B1**

(12) **FASCICULE DE BREVET EUROPEEN**

(45) Date de publication et mention
de la délivrance du brevet:
**05.11.2025 Bulletin 2025/45**

(21) Numéro de dépôt: **20820479.2**

(22) Date de dépôt: **31.07.2020**

(51) Classification Internationale des Brevets (IPC):
**G01D 3/08** *(2006.01)* **G01M 15/14** *(2006.01)*
**G01D 5/22** *(2006.01)*

(52) Classification Coopérative des Brevets (CPC):
**G01D 3/08; G01M 15/14;** G01D 5/2291

(86) Numéro de dépôt international:
**PCT/FR2020/051413**

(87) Numéro de publication internationale:
**WO 2021/019191 (04.02.2021 Gazette 2021/05)**

(54) **DÉTECTION AUTOMATIQUE D'UNE CONFIGURATION HARDWARE D'UN ÉQUIPEMENT EMBARQUÉ DANS UN AÉRONEF**

AUTOMATISCHE ERKENNUNG EINER HARDWARE-KONFIGURATION EINES GERÄTS AN BORD EINES FLUGZEUGS

AUTOMATIC DETECTION OF A HARDWARE CONFIGURATION OF EQUIPMENT ON BOARD AN AIRCRAFT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.07.2019 FR 1908754**

(43) Date de publication de la demande:
**01.06.2022 Bulletin 2022/22**

(73) Titulaire: **SAFRAN AIRCRAFT ENGINES**
**75015 Paris (FR)**

(72) Inventeurs:
• **GAUVRIT, Jacques Paul Michel**
  **77550 Moissy-Cramayel (FR)**
• **MASSON, Davy Philippe**
  **77550 Moissy-Cramayel (FR)**

(74) Mandataire: **Ernest Gutmann - Yves Plasseraud S.A.S.**
**C/o Plasseraud IP**
**104 Rue de Richelieu**
**CS 92104**
**75080 Paris Cedex 02 (FR)**

(56) Documents cités:
**US-A- 5 997 360** **US-A1- 2016 092 192**
**US-A1- 2016 245 144**

**Description**

Domaine technique de l'invention

La présente invention porte sur les équipements embarqués d'un aéronef, en particulier les équipements de régulation de carburant en particulier pour une turbomachine tel qu'un turboréacteur ou un turbopropulseur.

Etat de la technique antérieure

Il existe plusieurs calculateurs embarqués dans les aéronefs visant à la supervision des différents équipements embarqués, afin d'en assurer le bon fonctionnement. En particulier, les équipements dont le dysfonctionnement est critique, tel qu'une turbomachine, nécessite une supervision par deux calculateurs, un des calculateurs étant dédié à la redondance et étant utilisé en cas du dysfonctionnement du premier calculateur.

Ces calculateurs sont également appelés calculateur de protection. Une de leur mission est d'empêcher l'acheminement de carburant vers la turbomachine lorsqu'un dysfonctionnement est identifié pour éviter tout évènement catastrophique.

D'un modèle de turbomachine à l'autre, selon leur architecture, les calculateurs de protection peuvent être amenés à commander des équipements de régulation de carburant (en anglais FMU pour *Fuel Metering Unit*). Dans chaque FMU, le dosage du débit de carburant se fait grâce à un organe doseur généralement appelé FMV (pour « Fuel Metering Valve »). Cet organe FMV est piloté par le calculateur de contrôle EEC (Electronic Engine Control) de la turbomachine au travers d'une servovalve, lequel calculateur évalue le débit massique dosé Q par la formule suivante de calcul du débit traversant un orifice :

[Math 1]

$$Q = K_S * S\sqrt{\rho * \Delta P}$$

où ΔP est le différentiel de pression entre l'amont et l'aval du FMV, S la surface (section) de l'orifice laissant passer le fluide carburant dans le FMV, ρ la densité dudit fluide et Ks un paramètre lié au FMV.

L'organe doseur FMV comporte classiquement un élément mobile, dont la position est commandée de façon à faire varier la surface de l'orifice de passage du carburant. Une consigne de débit du calculateur de contrôle peut ainsi être transformée en consigne de position de l'élément mobile. Cet élément mobile peut être associé à un capteur de position linéaire LVDT (de l'anglais « Linear Variable Differential Transducer »). Lorsque l'élément est mobile en translation il est généralement appelé « tiroir ».

La position du tiroir telle que mesurée par le capteur LVDT est transmise au calculateur de contrôle EEC qui commande le déplacement du tiroir via une servovalve. Le débit massique dosé est fonction de la position du tiroir mobile, puisque le différentiel de pression est maintenu constant.

Il existe différents modèles d'équipements de régulation, présentant des caractéristiques matérielles différentes, et donc en particulier nécessitant des courants de commande d'intensités variables. Egalement, il est possible lors des opérations de maintenance de remplacer un premier modèle de FMU par un deuxième modèle de FMU. L'envoi d'un courant de commande d'intensité trop élevé peut endommager l'équipement de régulation et l'envoi d'un courant commande trop faible peut impacter la protection de la turbomachine en cas de dysfonctionnement.

Aujourd'hui, les informations relatives à l'architecture de la turbomachine, c'est-à-dire le nombre, le positionnement ainsi que le modèle de FMU utilisé est renseigné dans le logiciel applicatif de protection exécuté par les calculateurs de protection.

Ainsi une modification de modèle de FMU, lors d'une opération de maintenance, nécessite une modification du logiciel applicatif de protection pour éviter tout problème de fonctionnement.

Il est connu le document US 5 997 360 A.

L'invention a notamment pour but d'apporter une solution simple, efficace et économique aux inconvénients de la technique actuelle exposée ci-dessus.

Résumé de l'invention

A cette fin, il est proposé un procédé de détection d'une configuration matérielle d'un équipement, destiné à être embarqué dans une turbomachine et commandé par un calculateur de protection à deux voies, comprenant une alimentation apte à alimenter l'équipement, une première voie comprenant un premier boîtier de mesure apte à mesurer une première tension $V_{s1}$ en sortie de l'équipement et une seconde voie comprenant un deuxième boîtier de mesure apte à mesurer une deuxième tension $V_{s2}$ en sortie de l'équipement :

a) Envoyer en entrée de l'équipement une tension de commande *Vc* ;

b) Mesurer la première tension $V_{s1}$ et la deuxième tension $V_{s2}$ ;

c) Déduire la configuration matérielle de l'équipement, à partir des valeurs des première et seconde tensions mesurées $V_{s1}$ et $V_{s2}$.

Pour une tension de commande donnée (Vc), une configuration matérielle est associée à des valeurs spécifiques des première tension et seconde tension.

Lorsque l'équipement est, par exemple, un FMU, un tel procédé, implémenté sur un calculateur de protection permet, lors d'une phase de mise sous tension des équipements, c'est-à-dire au démarrage de ces derniers, de détecter automatiquement le modèle de FMU relié aux calculateurs de protection, et donc d'adapter le courant de contrôle à chaque modèle de FMU.

Ainsi en s'appuyant sur les caractéristiques électriques des modèles de FMU, il est possible d'en déduire leurs modèles. Pour cela, la réponse en tension d'une tension de commande est analysée de sorte à déduire automatiquement, c'est-à-dire sans intervention humaine, la configuration matérielle de chacun des équipements.

Ainsi, en faisant un test discriminant de la configuration, la solution assure le pilotage d'équipement de configuration matérielle hétérogène, tout en garantissant la fonction de protection contre les dysfonctionnements inopinés de la turbomachine (en anglais *Hazardous Engine Effects*).

De plus, l'équipement peut être un organe de dosage de carburant comprenant un élément mobile et ayant une configuration matérielle parmi les suivantes :

- une première configuration matérielle où l'organe de dosage de carburant comprend un organe de mesure de la position de l'élément mobile ;
- une deuxième configuration matérielle où l'organe de dosage de carburant ne comprend pas d'organe de mesure de position, et dont un câblage ou un câblage du harnais réalise un court-circuit entre un module de commande et les boîtiers de mesure du calculateur de protection ;
- une troisième configuration matérielle où l'organe de dosage de carburant ne comprend pas d'organe de mesure de position , et dont le câblage ou le câblage du harnais réalise un circuit ouvert entre le module de commande et les boîtiers de mesure, du calculateur de protection.

Le calculateur de protection est adapté à reconnaitre la configuration matérielle parmi l'une des trois configurations précitées à partir des valeurs des première et seconde tensions mesurées.

Il existe aujourd'hui trois configurations matérielles d'organe de dosage de carburant. La première configuration se caractérise par la présence d'un organe de mesure de la position de l'organe de dosage de carburant. Cet organe de mesure peut par exemple être un capteur électrique passif tel qu'un LVDT, alimenté en entrée par une tension de commande, et dont les bobinages peuvent fournir deux tensions de sortie dont les valeurs dépendent de la position de deux tiges mobiles reliées à l'organe de dosage de carburant. Les deuxième et troisième configurations matérielles, ne comprennent pas d'organe de mesure de la position de l'organe de dosage du carburant, l'information relative à la position de l'organe de dosage étant obtenue par exemple à partir d'une mesure du débit, et en connaissance des différents paramètres de la formule [Math 1], notamment le différentiel de pression aux bornes du doseur. Cette formule lie le débit à la section passante du doseur, laquelle est fonction de la position de l'organe mobile.

De plus, la tension de commande *Vc* est envoyé par le calculateur de protection.

En effet, les organes de dosages de carburant sont directement pilotés par le calculateur de protection apte en cas de dysfonctionnements à couper l'acheminement de carburant pour éviter tout évènement catastrophique tel qu'un départ en survitesse de la turbomachine qui pourrait avoir comme conséquence un éclatement de disque de turbine.

Ainsi, la tension de commande *Vc* peut être une tension continue inférieure à 15V.

En particulier, les première et seconde tensions mesurées $V_{s1}$ et $V_{s2}$ peuvent être chacune comparées à des valeurs seuils $S_1$, $S_2$ et $S_3$, telles que $S_1 < S_2 < S_3$, en particulier où $S_1 \in [0; 0,1 \times Vc]$, $S_2 \in [0,8 \times Vc; 0,9 \times Vc]$ *et* $S_3 \in [0,9 \times Vc; 1,1 \times Vc]$, *Vc* étant la tension de commande.

Egalement, la somme des première et seconde tensions mesurées $V_{s1}+V_{s2}$ peut être comparée à des valeurs seuils $S_3$, $S_4$ et $S_5$, telles que $S_3 < S_4 < S_5$, en particulier où $S_4 \in [0; 0,1 \times Vc]$, $S_5 \in [0,9 \times Vc; 1,1 \times Vc]$ *et* $S_6 \in [1,8 \times Vc; 2,2 \times Vc]$, *Vc* étant la tension de commande..

En fonction de la valeur des tensions $V_{s1}$ et $V_{s2}$ mesurées en sortie de l'organe de de dosage de carburant, en connaissance de la résistance de cet organe quelle qu'en soit sa structure, il est possible de déterminer la configuration matérielle de l'organe, et ceci de manière automatique. En d'autres termes, la réponse en tension de l'organe de dosage de carburant à une tension de commande de 7V envoyée par le calculateur, permet à celui, d'identifier, pour chacun des organes de dosage de carburant, sa configuration matérielle de manière automatique, lors de sa mise sous tension. Ainsi, le calculateur de protection peut ensuite adapter les niveaux de ces tensions de commande pour chacun des organes de dosage de carburant en fonction de sa configuration matérielle en d'autres termes de don modèle.

Le présent document porte également sur un programme d'ordinateur comprenant des instructions pour mettre en œuvre le procédé tel que décrit précédemment, lorsqu'il est exécuté sur un processeur.

Le présent document porte aussi sur un calculateur de protection comprenant un processeur couplé à une mémoire tel que le programme précité est enregistré sur la mémoire.

Brève description des figures

[Fig. 1] représente une première configuration d'un organe de dosage carburant ;
[Fig. 2] représente une deuxième configuration d'un organe de dosage carburant ;
[Fig. 3] représente une troisième configuration d'un organe de dosage carburant.

Description détaillée de l'invention

Lors d'opérations de maintenance, le remplacement d'un organe de dosage de carburant (connu sous l'acronyme anglais FMU) n'implique pas nécessairement un remplacement à l'identique, de sorte qu'un organe de dosage de carburant avec une première configuration matérielle peut être remplacé par un organe de dosage avec une deuxième configuration matérielle.

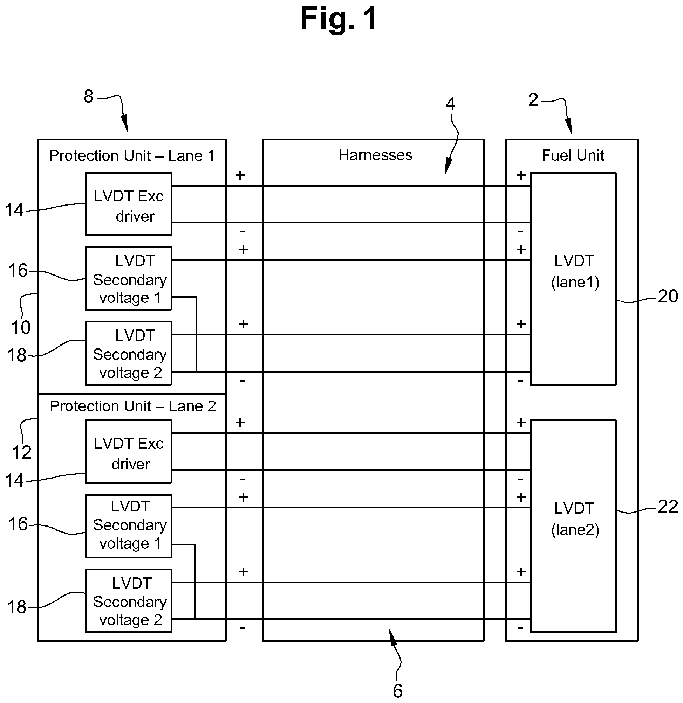

Trois modèles d'organes de dosage de carburant sont aujourd'hui utilisés, et présente une configuration matérielle propre respectivement illustrée aux figures 1, 2 et 3.

Comme on peut le voir, dans la turbomachine, les organes de dosage de carburant 2 sont reliés à par le bais de deux harnais distincts 4,6 à un calculateur de protection 8 à deux voies. Ce calculateur de protection 8 comprend en réalité deux calculateurs indépendants 10, 12, un principal et un secondaire, communiquant l'un avec l'autre et réalisant les mêmes opérations/calculs. Cette redondance du calculateur est notamment nécessaire en cas de dysfonctionnement du calculateur principal 10 : ce dernier est alors isolé et le calculateur secondaire 12 devient alors le calculateur en charge de la commande des équipements, notamment des organes de dosage de carburant 2.

Chacun des calculateurs 10, 12 de protection comprend :

- un module de commande 14, apte à envoyer des tensions de commande $Vc$ aux différents équipements 2 sous supervision du calculateur de protection 8. Cette tension de commande, propre à chaque équipement, est ainsi apte à alimenter l'équipement 2 cible.
- un premier 16 et un deuxième 18 boîtiers de mesure, apte à mesurer les tensions $V_{s1}$ et $V_{s2}$ émises en sortie des équipements en réponse à une tension de commande envoyé par le module de commande 14.

Egalement, bien que non représenté sur les figures 1 à 3, le calculateur comprend un processeur couplé à une mémoire, apte à réaliser des calculs pour commander les divers équipements supervisés par le calculateur de protection.

La première configuration matérielle du premier modèle d'organe de dosage de carburant 2 se caractérise par la présence d'un capteur passif électrique 20 permettant notamment d'obtenir la position de l'organe de dosage de carburant. Ce capteur est en général un capteur LVDT (acronyme anglais pour *Linear Variable Differential Transformer*), et est également redondé, se sorte que le premier capteur LVDT 20 étant connecté au premier calculateur 10 et le deuxième capteur LVDT 22 étant relié au deuxième calculateur 12.

Ainsi, en réponse à une tension d'alimentation provenant des modules de commande 14 de la première et seconde voie 10, 12 (c'est-à-dire du premier et du deuxième calculateur), les tensions $V_{s1}$ et $V_{s2}$ en sortie des capteurs LVDT 20, 22 sont respectivement mesurés sur les deux voies 10, 12.

Ce premier modèle est généralement appelé FMU Cutback.

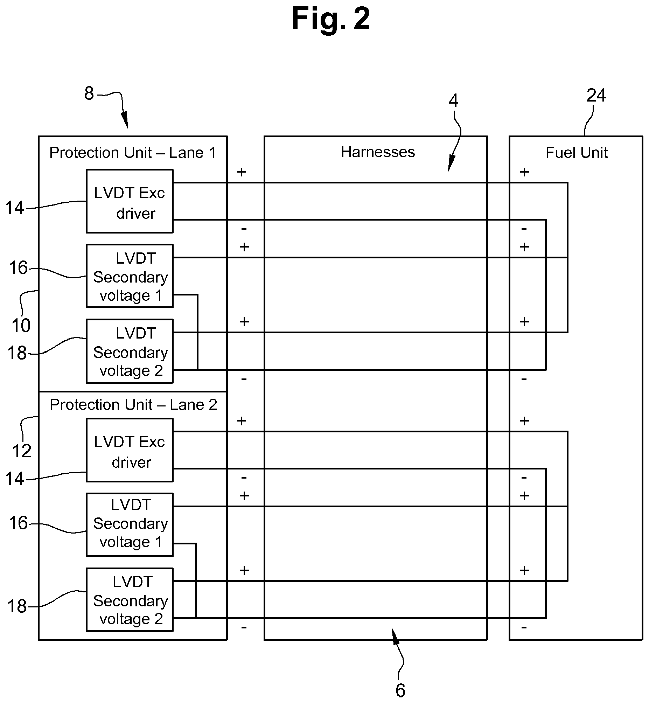

La deuxième configuration matérielle du deuxième modèle d'organe de dosage 24 de carburant se distingue de la première configuration matérielle du premier modèle de par l'absence de LVDT. Par conséquent, contrairement à la première configuration, le calculateur 8 ne reçoit aucun signal de retour d'un LVDT. En effet, comme cela est visible sur la figure 2, la tension de sortie de l'organe de l'alimentation du module de commande est égale à la tension en sortie de l'organe de dosage de carburant. En d'autres termes, un court-circuit volontaire est opéré, et ce sur les deux voies du calculateur de protection 10, 12. Les bornes du module de commande 14 sont directement reliées aux bornes des boitiers de mesures 16, 18. Le court-circuit est implémenté soit au niveau du harnais 4 soit directement au niveau de l'équipement, c'est-à-dire, de l'organe de dosage de carburant 24. Ainsi, la deuxième configuration matérielle est une configuration où l'organe de dosage de carburant 24 ne comprend pas d'organe de mesure de position 20, et son câblage ou le câblage du harnais réalise un court-circuit entre le module de commande 14 et les boîtiers de mesure 16, 18, du calculateur de protection 8 à deux voies.

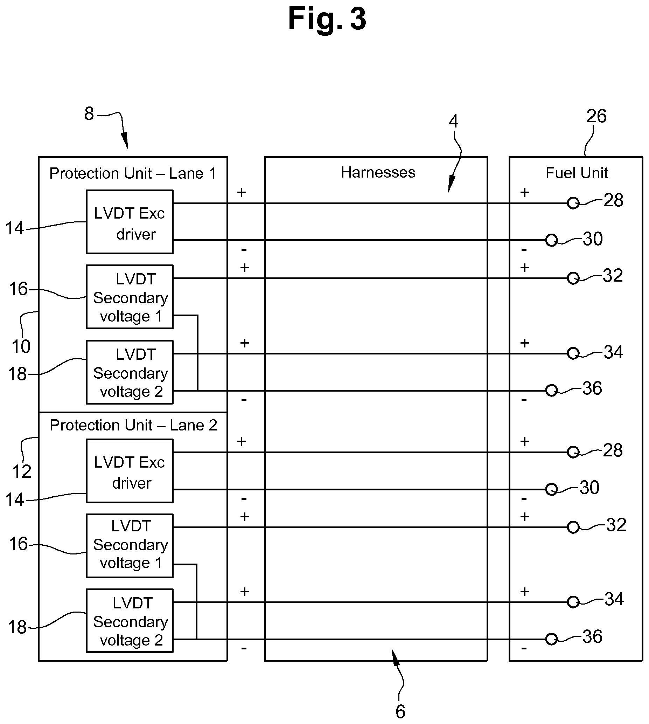

La troisième configuration matérielle du troisième modèle d'organe de dosage de carburant 26, comme la deuxième configuration, ne comprend pas de LVDT. La troisième configuration matérielle 26 se distingue de la deuxième configuration matérielle de par la création d'un circuit ouvert volontaire, sur les deux voies 10, 12. En effet, comme on peut le voir sur la figure 3, étant donné l'absence du LVDT, le calculateur 8 ne reçoit plus de signal provenant d'un capteur LVDT. En outre contrairement à la deuxième configuration 24, le module de commande 14 est relié à une première 28 et deuxième 30 bornes de l'organe de dosage de carburant 26 isolées entre elles de façon à former un circuit ouvert. Les boitiers de mesures de deux voies 10, 12, ne sont pas connectés au module de commande 14, mais à des troisième 32, quatrième 34 et cinquième 36 bornes isolées entre elles, ou en alternative reliées à une même masse. Ce troisième modèle 26 généralement appelé Baseline, se caractérise par un organe de dosage de carburant 24 qui ne comprend pas d'organe de mesure de position. De plus, son câblage ou le câblage du harnais de ce troisième modèle 26 réalise un circuit ouvert entre le module de commande 14 et les boîtiers de mesure 16, 18, du calculateur de protection 8 à deux voies.

Le procédé de détection du modèle d'organe de dosage de carburant utilisé s'appuie principalement sur les tensions mesurées par les boitiers de mesures, sous une alimentation de l'organe de dosage de carburant à une tension continue de 7V.

Il est implémenté sous la forme d'un programme d'ordinateur comprenant des instructions pour mettre en œuvre ce procédé de détection lorsqu'il est exécuté sur un processeur. Il est en particulier enregistré sur la mémoire du calculateur couplé au processeur, de sorte à être exécuté par le calculateur de protection. De cette manière, la détection de la configuration matérielle des organes de dosage de carburant reliés au calculateur de protection est automatique.

Le procédé de détection consiste, dans un premier temps, à envoyer en entrée de l'équipement, c'est-à-dire de l'organe de dosage 2, 24, 26, une tension de commande $Vc$. Cette tension de commande $Vc$ est une tension continue égale à 7 V.

Dans un deuxième temps, les boitiers de mesures 16, 18, mesurent respectivement la première tension $V_{s1}$ et la deuxième tension secondaire $V_{s2}$ délivrées en sortie de l'organe de dosage de carburant 2, 24, 26.

Selon les tensions mesurées $V_{s1}$ et $V_{s2}$, la configuration matérielle de l'organe de dosage de carburant 2, 24, 26, c'est-à-dire le modèle utilisé, est déduite. En effet, les configurations matérielles présentées ci-dessus se caractérisent par les valeurs de tensions suivantes :

[Tableau 1]

| Configuration matérielle de l'organe de dosage | Configuration 1 | Configuration 2 | Configuration 3 |
|---|---|---|---|
| $V_{S1}$ ou $V_{S2}$ | <6V | ~7V | ~0V |
| $V_{S1} + V_{S2}$ | ~7V | ~14V | ~0V |

Ainsi, la première configuration de l'organe de dosage de carburant 2, comprenant un capteur LVDT 20, dont le signal de sortie est mesuré, se caractérise par des tensions mesurées $V_{S1}$ et $V_{S2}$, telles que $V_{S1} < 6V$ et $V_{S2} < 6V$ et $V_{S1} + V_{S2} \sim 7V$.

La deuxième configuration de l'organe de carburant 24, ne comprenant pas de LVDT, se caractérise par des tensions mesurées $V_{S1}$ et $V_{S2}$, telles que $V_{S1} \sim 7V$ et $V_{S2} \sim 7V$ et $V_{S1} + V_{S2} \sim 14V$. En effet, du fait du court-circuit volontaire, les tensions $V_{S1}$ et $V_{S2}$, sont toutes deux environ égales à la tension continue délivrée par le module de commande, c'est-à-dire à une tension continue de 7V.

La troisième configuration de l'organe de carburant 26, ne comprenant pas de LVDT, se caractérise par des tensions mesurées $V_{S1}$ et $V_{S2}$, telles que $V_{S1} \sim 0V$ et $V_{S2} \sim 0V$ et $V_{S1} + V_{S2} \sim 0V$. En effet, du fait du circuit ouvert volontaire, les tensions $V_{S1}$ et $V_{S2}$, sont toute deux environ nulles.

Par conséquent, les tensions $V_{S1}$ et $V_{S2}$ sont comparées aux valeurs seuils $S_1$, $S_2$ et $S_3$ avec les valeurs respectives suivantes 0V, 6V et 7V. Alternativement, ou additionnellement, la somme des tensions mesurées est comparée aux valeurs seuils $S_3$, $S_4$ et $S_5$ avec les valeurs respectives suivantes : 0V, 7V et 14V.

De manière générales, les valeurs des seuils peuvent être comprises respectivement dans les intervalles suivants :

- $S_1 \in [0 ; 0{,}1 \times Vc]$, $S_2 \in [0{,}8 \times Vc ; 0{,}9 \times Vc]$ et $S_3 \in [0{,}9 \times Vc ; 1{,}1 \times Vc]$,
- $S_4 \in [0; 0{,}1 \times Vc]$, $S_5 \in [0{,}9 \times Vc; 1{,}1 \times Vc]$ et $S_6 \in [1{,}8 \times Vc; 2{,}2 \times Vc]$.

De préférence, l'ensemble des étapes de ce procédé sont exécutées par le calculateur de protection lors de la mise sous tension des équipements de l'aéronef.

**Revendications**

1. Procédé de détection d'une configuration matérielle d'un équipement (2) destiné à être embarqué dans une turbomachine d'aéronef et commandé par un calculateur de protection (8) à deux voies (10,12) constituant deux calculateurs indépendants, un principal et un secondaire, communiquant l'un avec l'autre et réalisant les mêmes opérations et/ou calculs, et comprenant chacun un module de commande (14) apte à envoyer une tension de commande *(Vc)* à l'équipement, un premier boîtier de mesure (16) apte à mesurer une première tension ($V_{s1}$) en sortie de l'équipement et un deuxième boîtier de mesure (18) apte à mesurer une deuxième tension ($V_{s2}$) en sortie de l'équipement,

   le procédé comprenant les étapes suivantes :

   a) Envoyer en entrée de l'équipement (2) une tension de commande *(Vc)* ;
   b) Mesurer la première tension ($V_{s1}$) et la deuxième tension ($V_{s2}$) ;
   c) Déduire la configuration matérielle de l'équipement (2), à partir des valeurs des première et seconde tensions mesurées ($V_{s1}$, $V_{s2}$), le calculateur de protection (8) étant adapté à reconnaître ladite configuration matérielle de l'équipement (2) à partir des valeurs des première et seconde tensions mesurées ($V_{s1}$, $V_{s2}$) ;

   ledit équipement étant un organe de dosage de carburant (2, 24, 26) comprenant un élément mobile et ayant une configuration matérielle parmi les suivantes :

   - une première configuration matérielle où l'organe de dosage de carburant (2) comprend un organe de mesure de la position (20) de l'élément mobile, les valeurs des première et seconde tensions de sortie ($V_{s1}$, $V_{s2}$) dépendant de la position de l'élément mobile;
   - une deuxième configuration matérielle où l'organe de dosage de carburant (24) ne comprend pas d'organe de mesure de position (20), et dont un câblage ou un câblage d'un harnais réalise un court-circuit entre un module de commande (14) et les boîtiers de mesure (16, 18) du calculateur de protection (8);
   - une troisième configuration matérielle où l'organe de dosage de carburant (26) ne comprend pas d'organe de mesure de position (20), et dont le câblage ou le câblage du harnais réalise un circuit ouvert entre le module de commande (14) et les boîtiers de mesure (16, 18), du calculateur de protection (8).

2. Procédé selon la revendication 1, dans lequel les trois configurations matérielles ont une même valeur de résistance.

3. Procédé selon l'une des revendications précédentes, dans lequel la tension de commande *(Vc)* est envoyée par le calculateur de protection (8).

4. Procédé selon l'une des revendications précédentes, dans lequel la tension de commande *(Vc)* est une tension continue inférieure à 15V.

5. Procédé selon l'une des revendications précédentes, dans lequel les première et seconde tensions mesurées ($V_{s1}$, $V_{s2}$) sont chacune comparées à des valeurs seuils $S_1$, $S_2$ et $S_3$, telles que $S_1 < S_2 < S_3$, en particulier où $S_1 \in [0; 0,1 \times Vc]$, $S_2 \in [0,8 \times Vc; 0,9 \times Vc]$ *et* $S_3 \in [0,9 \times Vc; 1,1 \times Vc]$, *Vc* étant la tension de commande.

6. Procédé selon l'une des revendications précédentes, dans lequel la somme ($V_{s1}+V_{s2}$) des première et seconde tensions mesurées ($V_{s1}$, $V_{s2}$) est comparée à des valeurs seuils $S_3$, $S_4$ et $S_5$, telles que $S_3 < S_4 < S_5$, en particulier où $S_4 \in [0; 0,1 \times Vc]$, $S_5 \in [0,9 \times Vc; 1,1 \times Vc]$ *et* $S_6 \in [1,8 \times Vc; 2,2 \times Vc]$, *Vc* étant la tension de commande.

7. Programme d'ordinateur comprenant des instructions pour mettre en œuvre le procédé selon l'une des quelconques revendications 1 à 6, lorsqu'il est exécuté sur un processeur d'un calculateur de protection (8) comportant un moyen adapté à envoyer en entrée d'un équipement (2) une tension de commande *(Vc)* ainsi que deux boîtiers de mesure (16, 18) adaptés à mesurer une première ($V_{s1}$) et une deuxième tension ($V_{s2}$) en sortie de l'équipement (2).

8. Calculateur de protection (8) comportant un moyen adapté à envoyer en entrée d'un équipement (2) une tension de commande *(Vc)* ainsi que deux boîtiers de mesure (16, 18) adaptés à mesurer une première ($V_{s1}$) et une deuxième tension ($V_{s2}$) en sortie de l'équipement (2), le calculateur de protection (8) comprenant en outre une mémoire sur laquelle est enregistré le programme selon la revendication 7 et un processeur couplé à la mémoire et configuré pour exécuter ledit programme.

**Patentansprüche**

1. Verfahren zum Erfassen einer Hardwarekonfiguration einer Vorrichtung (2), die dazu bestimmt ist, in einem Turbotriebwerk eines Luftfahrzeugs mitgeführt zu werden und von einem Schutzrechner (8) mit zwei Kanälen (10, 12) gesteuert wird, der zwei unabhängige Rechner bildet, nämlich einen Hauptrechner und einen Nebenrechner, die miteinander kommunizieren und die gleichen Operationen und/oder Berechnungen ausführen und jeweils ein Steuermodul (14) zum Anlegen einer Steuerspannung *(Vc)* an die Vorrichtung, ein erstes Messgehäuse (16) zum Messen einer ersten Spannung ($V_{s1}$) am Ausgang der Vorrichtung und ein zweites Messgehäuse (18) zum Messen einer zweiten Spannung ($V_{s2}$) am Ausgang der Vorrichtung umfassen,

   wobei das Verfahren die folgenden Schritte umfasst:

   a) Anlegen einer Steuerspannung *(Vc)* am Eingang der Vorrichtung (2);
   b) Messen der ersten Spannung ($V_{s1}$) und der zweiten Spannung ($V_{s2}$);
   c) Ableiten der Hardwarekonfiguration der Vorrichtung (2) aus den Messwerten der ersten und der zweiten Spannung ($V_{s1}$, $V_{s2}$), wobei der Schutzrechner (8) dazu ausgelegt ist, die Hardwarekonfiguration der Vorrichtung (2) aus den Messwerten der ersten und der zweiten Spannung ($V_{s1}$, $V_{s2}$) zu erkennen;

   wobei die Vorrichtung eine Kraftstoffdosiervorrichtung (2, 24, 26) ist, die ein bewegliches Element umfasst und eine der folgenden Hardwarekonfigurationen aufweist:

   - eine erste Hardwarekonfiguration, bei der die Kraftstoffdosiervorrichtung (2) eine Stellungsmessvorrichtung (20) zum Messen der Stellung des beweglichen Elements umfasst, wobei die Werte der ersten und der zweiten Ausgangsspannung ($V_{s1}$, $V_{s2}$) von der Stellung des beweglichen Elements abhängen;
   - eine zweite Hardwarekonfiguration, bei der die Kraftstoffdosiervorrichtung (24) keine Stellungsmessvorrichtung (20) umfasst und deren Verkabelung oder Kabelbaum einen Kurzschluss zwischen einem Steuermodul (14) und den Messgehäusen (16, 18) des Schutzrechners (8) herstellt;
   - eine dritte Hardwarekonfiguration, bei der die Kraftstoffdosiervorrichtung (26) keine Stellungsmessvorrichtung (20) umfasst und deren Verkabelung oder Kabelbaum einen offenen Stromkreis zwischen dem Steuermodul (14) und den Messgehäusen (16, 18) des Schutzrechners (8) herstellt.

2. Verfahren nach Anspruch 1,
   wobei die drei Hardwarekonfigurationen denselben Widerstandswert haben.

3. Verfahren nach einem der vorstehenden Ansprüche,
   wobei die Steuerspannung *(Vc)* vom Schutzrechner (8) angelegt wird.

4. Verfahren nach einem der vorstehenden Ansprüche,
   wobei die Steuerspannung *(Vc)* eine Gleichspannung von weniger als 15 V ist.

5. Verfahren nach einem der vorstehenden Ansprüche,
   wobei die erste und die zweite Messspannung ($V_{s1}$, $V_{s2}$) jeweils mit Schwellenwerten $S_1$, $S_2$ und $S_3$ verglichen werden, sodass $S_1 < S_2 < S_3$ gilt, insbesondere wobei $S_1 \in [0; 0,1 \times Vc]$, $S_2 \in [0,8 \times Vc; 0,9 \times Vc]$ und $S_3 \in [0,9 \times Vc; 1,1 \times Vc]$ ist, wobei *Vc* die Steuerspannung ist.

6. Verfahren nach einem der vorstehenden Ansprüche,
   wobei die Summe ($V_{s1} + V_{s2}$) der ersten und der zweiten Messspannung ($V_{s1}$, $V_{s2}$) mit Schwellenwerten $S_3$, $S_4$ und $S_5$ verglichen wird, wobei $S_3 < S_4 < S_5$ gilt, insbesondere wobei $S_4 \in [0; 0,1 \times Vc]$, $S_5 \in [0,9 \times Vc; 1,1 \times Vc]$ und $S_6 \in [1,8 \times Vc; 2,2 \times Vc]$ ist, wobei *Vc* die Steuerspannung ist.

7. Computerprogramm mit Anweisungen zur Durchführung des Verfahrens nach einem der Ansprüche 1 bis 6, wenn es auf einem Prozessor eines Schutzrechners (8) ausgeführt wird, der eine Einrichtung zum Anlegen einer Steuerspannung *(Vc)* an den Eingang einer Vorrichtung (2) sowie zwei Messgehäuse (16, 18) zum Messen einer ersten ($V_{s1}$) und einer zweiten Spannung ($V_{s2}$) am Ausgang der Vorrichtung (2) umfasst.

8. Schutzrechner (8) mit einer Einrichtung zum Anlegen einer Steuerspannung *(Vc)* an den Eingang einer Vorrichtung (2) sowie zwei Messgehäusen (16, 18) zum Messen einer ersten ($V_{s1}$) und einer zweiten Spannung ($V_{s2}$) am Ausgang der Vorrichtung (2), wobei der Schutzrechner (8) ferner einen Speicher umfasst, in dem das Programm nach Anspruch 7 hinterlegt ist, sowie einen mit dem Speicher gekoppelten Prozessor, der zur Ausführung des Programms konfiguriert ist.

**Claims**

1. Method for detecting a hardware configuration of a device (2) intended to be carried aboard an aircraft turbomachine and controlled by a two-channel (10, 12) protection computer (8) constituting two independent calculators, a main one and a secondary one, communicating with each other and performing the same operations and/or calculations, and comprising each a control module (14) able to send a control voltage ($Vc$) to the device, a first measuring box (16) able to measure a first voltage ($V_{s1}$) at the output of the device and a second measuring box (18) capable of measuring a second voltage ($V_{s2}$) at

   the output of the device, the method comprising the following steps :

   a) Sending a control voltage ($Vc$) to the input of the device (2);
   b) Measuring the first voltage ($V_{s1}$) and the second voltage ($V_{s2}$);
   c) Inferring the hardware configuration of the device (2) from the values of the first and second voltages measured ($V_{s1}$, $V_{s2}$),

   the protection computer (8) being adapted to recognize said hardware configuration of the device (2) from values of the first and second voltages measured ($V_{s1}$, $V_{s2}$);
   the device being a fuel-metering unit (2, 24, 26) comprising a movable element and having one of the following hardware configurations:

   - a first hardware configuration where the fuel-metering unit (2) comprises a position-measuring unit (20) for the movable element;
   - a second hardware configuration where the fuel metering member (24) does not comprise a position-measuring unit (20), and where a wiring or a harness wiring establishes a short circuit between a control module (14) and the measuring boxes (16, 18) of the protection computer (8);
   - a third hardware configuration where the fuel-metering unit (26) does not include a position-measuring unit (20), and where the wiring or harness wiring establishes an open circuit between the control module (14) and the measuring boxes (16, 18) of the protection computer (8).

2. Method according to claim 1, wherein the three hardware configurations have the same resistance value.

3. Method according to one of the preceding claims, wherein the control voltage ($Vc$) is sent by the protection computer (8).

4. Method according to one of the preceding claims, wherein the control voltage ($Vc$) is a DC voltage of less than 15V.

5. Method according to one of the preceding claims, wherein the first and second voltages measured ($V_{s1}$, $V_{s2}$) are each compared with threshold values $S_1$, $S_2$ and $S_3$, such that $S_1 < S_2 < S_3$ in particular where $S_1 \in [0; 0,1 \times Vc]$, $S_2 \in [0,8 \times Vc; 0,9 \times Vc]$ et $S_3$ E $[0,9 \times Vc; 1,1 \times Vc]$, $Vc$ being the control voltage.

6. Method according to one of the preceding claims, wherein the sum ($V_{s1}+V_{s2}$) of the first and second voltages measured ($V_{s1}$, $V_{s2}$) is compared with threshold values $S_3$, $S_4$ and $S_5$, such that $S_3 < S_4 < S_5$, in particular where $S_4 \in [0; 0,1 \times Vc]$, $S_5 \in [0,9 \times Vc; 1,1 \times Vc]$ et $S_6 \in [1,8 \times Vc; 2,2 \times Vc]$, $Vc$ being the control voltage.

7. Computer program comprising instructions for implementing the method according to one of claims 1 to 6, when executed on a processor of a protection computer (8) comprising a means adapted to send to the input of a device (2) a control voltage ($Vc$) and two measuring boxes (16, 18) adapted to send to measure a first ($V_{s1}$) and a second ($V_{s2}$) voltage at the output of the device (2).

8. Protection computer (8) comprising a means adapted to send to the input of a device (2) a control voltage ($Vc$) and two measuring boxes (16, 18) adapted to send to measure a first ($V_{s1}$) and a second ($V_{s2}$) voltage at the output of the device (2), the protection computer (8) further comprising a memory onto which is stored the program according to claim 7 and a processor coupled to the memory and configured to execute said program.

# Fig. 1

# Fig. 2

# Fig. 3

## RÉFÉRENCES CITÉES DANS LA DESCRIPTION

**Documents brevets cités dans la description**

- US 5997360 A